(19) Europäisches Patentamt
European Patent Office
Office européen des brevets

(11) EP 1 130 469 A1

(12) EUROPEAN PATENT APPLICATION

(43) Date of publication:
05.09.2001 Bulletin 2001/36

(51) Int Cl.[7]: G03F 7/039, G03F 7/004

(21) Application number: 00307367.3

(22) Date of filing: 29.08.2000

(84) Designated Contracting States:
AT BE CH CY DE DK ES FI FR GB GR IE IT LI LU MC NL PT SE
Designated Extension States:
AL LT LV MK RO SI

(30) Priority: 22.02.2000 US 511004

(71) Applicant: LUCENT TECHNOLOGIES INC.
Murray Hill, New Jersey 07974-0636 (US)

(72) Inventors:
- Houlihan, Francis M.
  Millington, New Jersey 07946 (US)
- Nalamasu, Omkaram
  Bridgewater, New Jersey 08807 (US)
- Yan, Zhenglin
  Scotch Plains, New Jersey 07076 (US)

(74) Representative: Williams, David John et al
Page White & Farrer,
54 Doughty Street
London WC1N 2LS (GB)

# (54) A radiation-sensitive resist material and a process for device fabrication using the same

(57) A process for device fabrication and resist materials that are used in the process are disclosed. The resist material contains a polymer in combination with a dissolution inhibitor and a photoacid generator (PAG). The dissolution inhibitor is an aliphatic carboxylic acid derivative that has at least two acid labile groups and a third substituent that is either a hydrophilic moiety with an acid labile group, a saturated linear, branched, cyclic or alicyclic hydrocarbon moiety having no more than about 18 carbon atoms, an oxyalkyl moiety, a sulfur-containing moiety, a hydroxy moiety or a cyano moiety. The polymer optionally has acid labile groups pendant thereto which significantly decrease the solubility of the polymer in a solution of aqueous base. A film of the resist material is formed on a substrate and exposed to delineating radiation. The radiation induces a chemical change in the resist material rendering the exposed resist material substantially more soluble in aqueous base solution than the unexposed portion of the resist material. The image introduced into the resist material is developed using conventional techniques, and the resulting pattern is then transferred into the underlying substrate.

EP 1 130 469 A1

## Description

### BACKGROUND OF THE INVENTION

### TECHNICAL FIELD

The invention is directed to a process for device fabrication in which an energy sensitive resist material containing a dissolution inhibitor is used.

### ART BACKGROUND

Devices such as integrated circuits are complex structures made of a variety of materials. These materials are precisely configured to form the desired device by a variety of processes. A lithographic process is frequently used to transfer the desired configuration into a substrate to fabricate such devices.

Lithographic processes use intermediate materials frequently referred to as resists. A positive or negative image of the desired configuration is first introduced into the resist by exposing it to patterned radiation, which induces a chemical change in the exposed portions of the resist. This chemical change is then exploited to develop a pattern in the resist, which is then transferred into the substrate underlying the resist.

The efficacy of a lithographic process depends at least in part on the resist used to transfer the pattern into the substrate. Certain types of resists offer particular advantages in the context of specific lithographic processes. For example, solution-developed resists are designed to have absorption characteristics appropriate for use at certain exposure wavelengths. It is axiomatic that, if the resist material is opaque to the exposing radiation, the exposing radiation will not be transmitted into the resist material and the desired chemical change will not occur. Therefore it is important to select a resist material that has the appropriate light transmission characteristics at the wavelength of the exposing radiation. Other considerations that drive the selection of an appropriate resist material include the etch resistance of the resist after it has been exposed and developed.

In this regard, resist materials that contain polymers with ethylenic and/or aromatic unsaturation are typically used in lithographic processes for device fabrication in which the wavelength of the exposing radiation is in the traditional ultraviolet (UV) or deep UV range (i.e., about 240 nm to about 370 nm). However, these resist materials are often not suitable in processes in which the exposing radiation is 193 nm because the carbon-carbon double bond absorbs radiation at this wavelength. Consequently, resist materials that are being used for lithographic processes in which the exposing radiation has a wavelength of 248 nm or more are generally not useful in processes that use exposing radiation with a wavelength of 193 nm. Since lithographic processes for fabricating devices using 0.13 μm and 0.10 μm design rules are likely to use 193 nm-wavelength light as the exposing radiation, resist polymers that do not contain significant amounts of ethylenic unsaturation have been developed. Examples of such resist polymers, and resist materials that contain such polymers, are described in U.S. Patent No. 5,843,624 to Houlihan et al., U.S. Patent No. 5,725,996 to Houlihan et al. and U.S. Patent No. 5,879,857 to Chandross et al., all of which are incorporated by reference herein. Additional resist materials that are useful in lithographic processes in which the exposing radiation is 193 nm are sought.

### SUMMARY OF THE INVENTION

The present invention is directed to a lithographic process for device fabrication which utilizes an energy sensitive resist material that contains a polymer combined with a dissolution inhibitor and a photoacid generator (PAG). The dissolution inhibitor is a derivative of an aliphatic carboxylic acid. As such, the dissolution inhibitor has at least two carboxylic acid moieties. Each carboxylic acid moiety has an acid labile group. The derivative of the aliphatic carboxylic acid has the following formula:

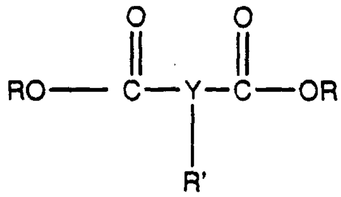

wherein the carboxylic acid moieties are -COOR. R is a group that is removed from the moiety in the presence of acid. Such acid labile groups are well known to one skilled in the art. The acid labile moiety renders the compound less soluble than it otherwise would be if the hydrogen was not so replaced. The acid labile group provides the dissolution

inhibitor with the desired degree of insolubility in aqueous base before the resist material in which it is incorporated is exposed to radiation. Upon irradiation and, typically, a post-exposure bake, a sufficient portion of these acid labile groups are cleaved to render the resist material soluble in aqueous base.

Examples of suitable acid labile groups R include t-butyl, t-amyl 1-methylcyclohexyl, 3-oxocyclohexyl, and bis(2-trimethylsilyl)ethyl, and other groups that easily undergo cleavage from the hydrophilic moiety in the presence of the photoacid. A broad range of these acid labile substituents is well known to one skilled in the art. In the presence of acid, these groups produce a free carboxylic acid and an acidolysis or acid-catalyzed hydrolysis byproduct.

The aliphatic portion of the dissolution inhibitor of the present invention is designated as Y. Y is an aliphatic moiety that is a linear or branched chain alkyl, cyclic alkyl, or an alicyclic alkyl group. In addition to the carboxylic acid moieties depicted above, Y has at least one additional substituent that is designated as R'. R' is a substituent with an acid labile group, an alkyl substituent, an alkoxy substituent, a sulfone substituent, a hydroxy substituent or a cyano substituent.

Examples of R' substituents having an acid labile group include the carboxylic moieties described above. However, R' is not limited to carboxylic acid substituents and can include other hydrophilic moieties that are masked by an acid labile group.

Examples of R' alkyl groups include linear or branched chain alkyl moieties, cyclic alkyl moieties, or alicyclic alkyl moieties that have 1-18 carbon atoms. Alkyl substituents include saturated perfluoroalkyl moieties. Examples of oxyalkyl R' substituents are alkyl groups with carbonyl, carbonate or carboxylate moieties. Examples of sulfone R' substituents include alkyl groups with sulfone or sulfoxide moieties. Examples of cyano R' substituents include alkyl cyano substituents.

When the third substituent is an acid labile substituent, the dissolution inhibitor has a greater $R_{max}$ (the maximum dissolution rate) than dissolution inhibitors with two or fewer acid labile substituents. The dissolution rate is measured as a change in thickness as a function of time. When the third substituent is an alkyl, oxyalkyl, sulfone or cyano substituent, the dissolution inhibitor has greater solubility more soluble spinning solvent, more miscibility in the resist composition compared to dissolution inhibitors that do not have such substituents. Of course, the present invention contemplates dissolution inhibitors in which the Y moiety has more than one R' substituent.

When the Y moiety has more than one cyclic alkyl moiety, it is contemplated that the cyclic moieties are linked together with a linking moiety. That linking moiety is selected from the group consisting of oxygen, branched or straight chain alkyl moieties having 1-18 carbon atoms, alicyclic moieties, sulfur or sulfur-containing moieties (e.g., $SO_2$, S, SO), carboxyl moieties ($CO_2$), carbonate moieties ($CO_3$) and carbonyl moieties (CO).

In the present invention, the Y moiety and the substituents are selected so that the molecular weight of the compound is less than about 2000.

In certain embodiments of the present invention, the previously described dissolution inhibitor is the sole dissolution-inhibiting component in the resist material. In other embodiments, the resist material contains the above-described dissolution inhibitor in combination with another dissolution inhibiting component. In the embodiments of the present invention wherein the resist material contains two or more dissolution inhibitors, the other dissolution inhibitors are selected to work with the dissolution inhibitor of the present invention. That is, the additional dissolution inhibitors also have acid labile groups that cleave from the dissolution inhibitors in the presence of acid. When the acid labile groups are cleaved the dissolution inhibitors and, in turn, the resist materials are rendered more soluble in an aqueous basis developer (compared to their solubility before the acid labile groups were cleaved). Examples of suitable additional dissolution inhibitors are oligomeric and monomeric cholate-based dissolution inhibitors described in U.S. Patent No. 5,879,857 to Chandross et al.

In one embodiment of the present invention, the dissolution inhibitor is a blend. The blend is a combination of the dissolution promoter (the aliphatic carboxylic acid derivative described above except that the Y moiety is either substituted or unsubstituted) and a cholate-based dissolution inhibitor. It is advantageous if the total dissolution inhibitor is about 95 weight percent to about 5 weight percent of the dissolution promoter the aliphatic carboxylic acid and about 5 weight percent to about 95 weight percent of the cholate-based compound.

In the process of the present invention, the dissolution inhibitor combined with a polymer and, typically, an energy-sensitive compound such as a PAG is used as an energy-sensitive material. It is contemplated that other additives, such as amines that reduce the diffusion of acid from the exposed region to the unexposed region and that provide greater resistance to environmental contamination, will also be added to the composition. The combination of polymer and dissolution inhibitor is about 2 weight percent to about 50 weight percent dissolution inhibitor and about 98 weight percent to about 50 weight percent polymer. To this is added about 0.5 weight percent to about 20 weight percent PAG. The combination of polymer, dissolution inhibitor, PAG, and other additives (if present) are then combined with a spinning solvent such as polyglycol methylether acetate (PGMEA) and applied onto a substrate. Although the amount of solids (i.e. the polymer, dissolution inhibitor, PAG and other additives) relative to the amount of solvent is largely a matter of design choice, it is advantageous if the amount of solids is about 5 weight percent to about 30 weight percent and the amount of spinning solvent is about 70 weight percent to about 95 weight percent.

In the process, the energy-sensitive material is selectively exposed to radiation with a wavelength in the range of about 190 nm to about 300 nm to form an image of a desired pattern in the energy-sensitive material. That pattern is then developed and used in subsequent processing. Because the dissolution inhibitors described herein do not significantly absorb radiation at 193 nm, the dissolution inhibitors are particularly advantageous if used in lithographic processes in which the exposing radiation has a wavelength of about 193 nm.

Consequently, it is advantageous if the polymer selected for use in conjunction with the dissolution inhibitor is also compatible with lithographic processes for device fabrication in which the exposing radiation is about 190 nm to about 300 nm. Polymers contemplated for use in the process of the present invention include acrylate-based resins that are soluble in aqueous base solution (including resins in which the aqueous base solubility is "masked" by acid labile groups). Examples of such acrylate-based resins are described in Allen, R.D., et al., Photopolymer Science and Technology, Vol. 8, p. 623 (1995) which is incorporated by reference herein. Other examples of suitable polymers include the polymers with saturated alicyclic moieties described in U.S. Patent No, 5,843,624 to Houlihan et al. wherein the saturated alicyclic moieties are incorporated either in the polymer backbone or attached to the polymer backbone via saturated hydrocarbon linkages.

In the embodiment of the present invention in which the polymer contains alicyclic moieties, it is advantageous if about 25 mole percent to about 50 mole percent of the polymer constitutes monomers that contain these alicyclic moieties. For convenience herein, the polymer is described in terms of the individual molecules (i.e., monomers) that are polymerized to form the polymer. The alicyclic moiety is advantageous because the polymers with alicyclic moieties therein have an advantageous resistance to plasma etching that is useful in processes for device fabrication. Examples of suitable polymers include terpolymers of norbornene, maleic anhydride and acrylic acid or methacrylic acid. Further examples include tetrapolymers of norbornene, maleic anhydride, acrylic acid, or methacrylic acid, and acrylate or methacrylate.

In one embodiment of the present invention, the resist polymer does not have acid labile groups pendant thereto and is inherently soluble in aqueous base. In a second embodiment, the resist polymer does have, to some fraction of its monomer units, acid labile groups pendant thereto and is inherently insoluble in aqueous base unless and until some significant amount of those acid labile groups are cleaved from the polymer and replaced by hydrogen atoms.

One example of an inherently soluble polymer is a copolymer of a cycloolefin such as substituted or unsubstituted norbornene, maleic anhydride, and at least one other monomer. If the cycloolefin is unsubstituted, then at least one of the other monomers should contain a free carboxylic acid. Acrylic acid and methacrylic acid are examples of suitable monomers. If the cycloolefin is substituted with an acidic functionality, such as a carboxylic acid group, the other monomers are not required to contain a free carboxylic acid functionality.

In the embodiment wherein the polymer is inherently insoluble, the contrast between the unexposed and exposed portions of the resist material results from the aqueous base solubility of both the polymer and the dissolution inhibitor being altered by the acid generated by the PAG. The PAG generates the acid when the resist material is exposed to radiation and post-exposure baked.

In the process of the present invention, generally, the resist material containing the components described generally above is formed into a film on the surface of a substrate that is typically a silicon wafer. The silicon wafer will typically have layers of other materials formed thereon. These wafers, with or without layers of other materials formed thereon, are referred to herein as substrates.

The resist-coated substrate is then subjected to a patternwise exposure to radiation to delineate the image of a pattern into the energy-sensitive resist material. A chemical agent, the photoacid generated in the course of the irradiation, effects a chemical change (typically upon heating), which enhances the aqueous base solubility of the irradiated portion of the resist. The resist materials of the present invention are contemplated as useful in lithographic processes in which the exposing radiation is ultraviolet (UV) radiation with a wavelength of about 190 nm to about 300 nm.

After the image of the pattern is delineated in the resist material, the image is developed into a pattern by exploiting the difference in aqueous base solubility between the exposed resist material and the unexposed resist material. In the context of the present invention, the term "exposed resist material" implies the portion of the resist whose aqueous base solubility has been increased by exposure to the photoacid and, typically, heat.

After the development, the pattern in the resist is transferred into the underlying substrate using conventional etching expedients well known to one skilled in the art.

## DETAILED DESCRIPTION

The present invention is directed to a class of energy-sensitive resist materials that are useful in lithographic processes for device fabrication. Processes for device fabrication which include lithographic steps have been described in treatises such as S.M. Sze, VLSI Technology, (McGraw-Hill pub. 1983) and L.F. Thompson et al., Introduction to

Microlithography, pp. 87-161 (American Chemical Society Symposium Series 219, 1983) which are hereby incorporated by reference. Lithographic steps typically include exposing and patterning energy definable materials such as resist materials. An image is first introduced into the resist and developed to form a pattern, which is then transferred into the substrate.

The materials are energy-sensitive; i.e., energy induces a chemical change in these materials. When these materials are exposed to either patterned radiation of the appropriate wavelength, i.e., UV light with a wavelength of about 190 nm to about 370 nm, the chemical change is induced to a significantly greater extent in the portion of the resist material that is directly exposed to radiation than in the portion of the resist material that is not directly exposed to radiation. In the context of the present invention, significantly greater means that the chemical contrast induced by the patternwise exposure is adequate to meet processing objectives. This chemical difference is exploited to develop the pattern in the energy-sensitive resist material. The developed pattern is then used in subsequent processing, e.g., transfer of the developed pattern into an underlying substrate.

Aqueous base solutions are typically used to develop patterns in energy sensitive resist materials. One common example of an aqueous base solution is an aqueous solution of tetramethylammonium-hydroxide (TMAH) that is about 0.05 M to about 0.5 M, although many other solutions are well known to one skilled in the art.

In the positive-tone resist materials of the present invention, the material that is not exposed to radiation is relatively insoluble in the aqueous base developer solution relative to the material that is exposed to radiation. This difference in aqueous base solubility is affected primarily by manipulating the aqueous base solubility of a dissolution inhibitor in the energy-sensitive resist material.

As previously described, the dissolution inhibitor is an aliphatic carboxylic acid derivative. As such the compound is a saturated, linear, branched, cyclic, or alicyclic hydrocarbon compound with at least two carboxylic acid moieties. Each carboxylic acid moiety has an acid labile group. The compound has the general structure:

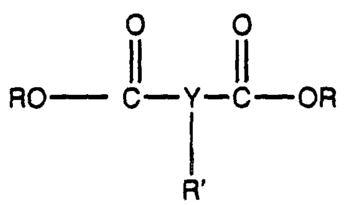

R is an acid labile substituent such as t-butyl, t-amyl 1-methylcyclohexyl, 3-oxocyclohexyl, and bis(2-trimethylsilyl)ethyl, and other substituents that easily undergo cleavage of the acid labile group in the presence of the photoacid.

The aliphatic portion of the dissolution inhibitor of the present invention is designated as Y. Y is an aliphatic moiety-that is a linear or branched chain alkyl, cyclic alkyl, or an alicyclic alkyl group. In addition to the carboxylic acid moieties having acid labile groups, Y has at least one additional substituent that is designated as R'. Examples of suitable R' substituents include a hydrophilic moiety with an acid labile group, an alkyl substituent, an alkoxy substituent, a sulfone substituent, a hydroxy substituent or a cyano substituent.

In the embodiments where R' is a hydrophilic moiety with an acid labile group, suitable R' substituents include, in addition to the carboxylic acid moieties with acid labile groups described above, the following:

<table>
<tr><th>R' is a Hydrophilic Moiety with an Acid Labile Group</th><th>Representative Structure</th></tr>
<tr><td>hydroxy</td><td>-O-R</td></tr>
<tr><td>alkyl carboxylic acid</td><td>O<br>||<br>-R"-C-OR</td></tr>
<tr><td>alkyl carbonic acids</td><td>O<br>||<br>-R"-O-C-OR</td></tr>
<tr><td>alkyl hydroxy</td><td>-R"-O-R</td></tr>
</table>

wherein R is as previously defined and R" is an alkyl, cyclic alkyl or alicyclic alkyl moiety with 1-18 carbon atoms.

Examples of suitable alkyl R' substituents include linear or branched chain alkyl moieties, cyclic alkyl moieties, or alicyclic alkyl moieties that have 1-18 carbon atoms. Alkyl substituents also include saturated perfluoroalkyl moieties.

Alkoxy R' substituents contain at least one carbonyl moiety. Examples of suitable R' alkoxy substituents include the following:

<table>
<tr><th>R' is an alkoxy substituent with at least one carbonyl moiety</th><th>Representative Structure</th></tr>
<tr><td>alkyl carboxylate</td><td>O<br>||<br>-R"-C-O-R"</td></tr>
<tr><td>alkyl carbonate</td><td>O<br>||<br>-R"-O-C-O-R"</td></tr>
<tr><td>carboxylate</td><td>O<br>||<br>-C-O-R"</td></tr>
<tr><td>carbonate</td><td>O<br>||<br>-O-C-O-R"</td></tr>
<tr><td>oxycarbonyl</td><td>O<br>||<br>-O-C-R"</td></tr>
<tr><td>alkyl oxycarbonyl</td><td>O<br>||<br>-R"-O-C-R"</td></tr>
<tr><td>alkyl carbonyl</td><td>O<br>||<br>-R"-C-R"</td></tr>
<tr><td>carbonyl</td><td>O<br>||<br>-C-R"</td></tr>
</table>

wherein R" is as previously defined.

Examples of suitable sulfur-containing R' substituents include:

| R' is a sulfur containing substituent | Representative Structure |
|---|---|
| sulfone alkyl | O<br>\|\|<br>-S-R"<br>\|\|<br>O |
| alkyl sulfone alkyl | O<br>\|\|<br>-R"-S-R"<br>\|\|<br>O |
| sulfoxide alkyl | O<br>\|\|<br>-S-R" |
| alkyl sulfoxide alkyl | O<br>\|\|<br>R"-S-R" |

wherein R" is as previously defined.

Examples of suitable R' hydroxy substituents include hydroxy (-OH), secondary alkyl hydroxy (-R"CHOHR") and tertiary alkyl hydroxy (-R"C $R''_2$ OH). Examples of suitable R' cyano substituents include cyano (-CN) and alkyl cyano (-R"CN).

When the third substituent is a hydrophilic substituent with an acid labile group, the dissolution inhibitor has a greater $R_{max}$ than dissolution inhibitors with two or fewer acid labile substituents. When the third substituent is an alkyl, oxyalkyl or cyano substituent, the dissolution inhibitor has greater solubility compared to dissolution inhibitors that do not have such substituents. Of course, the present invention contemplates dissolution inhibitor with more than one R' substituent.

When the Y moiety has more than one cyclic alkyl moiety, it is contemplated that the cyclic moieties are linked together with a linking moiety. That linking moiety is selected from the group consisting of oxygen, branched or straight chain alkyl moieties having 1-18 carbon atoms, alicyclic moieties, sulfur or sulfur-containing moieties (e.g., $SO_2$, S, SO) carboxyl moieties ($CO_2$) carbonate moieties ($CO_3$) and carbonyl moieties (CO).

In the present invention, the Y moiety and the substituents are selected so that the molecular weight of the compound is less than about 2000. Examples of compounds in which Y is a cyclic or alicyclic compound include:

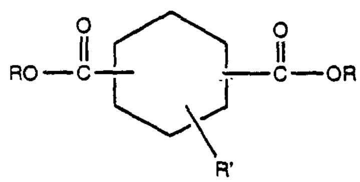
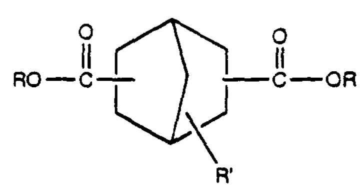

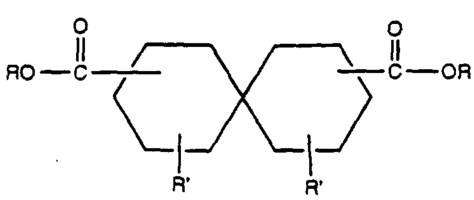
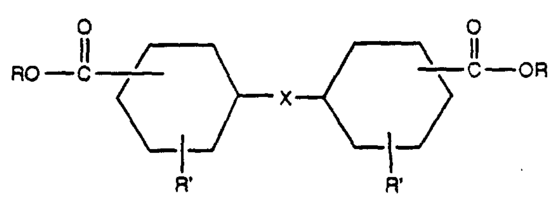

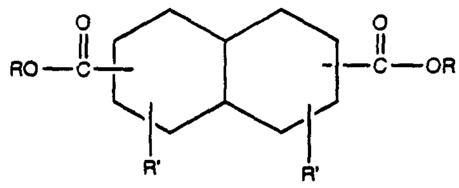

where X is the above-described linking moiety.

Examples of dissolution inhibitors in which Y is an alkyl moiety include:

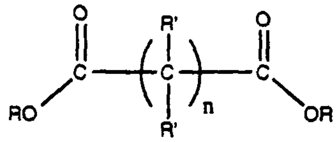

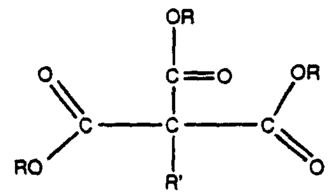

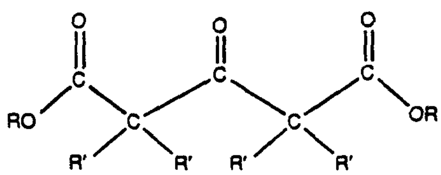

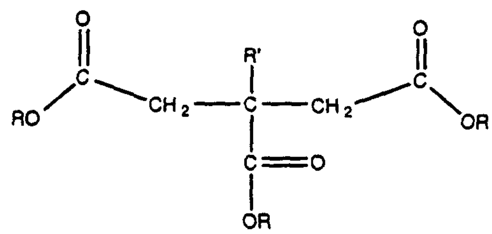

wherein n is 1 to 18 and R and R' are as previously described.

The Y moiety is substituted to increase the molecular weight of the dissolution inhibitor and thereby reduce its volatility. In this regard it is advantageous if the dissolution inhibitor has a molecular weight greater than about 300 and a boiling point greater than about 300°C.

In the embodiment wherein the resist material contains more than one dissolution inhibitor, the aliphatic carboxylic acid derivative dissolution inhibitor functions as a dissolution promoter when combined with a cholate-based dissolution inhibitor having acid labile substituents. The dissolution promoter is the same as the above-described unsaturated carboxcyclic acid, except that Y is either substituted or unsubstituted. In this embodiment, the molecular weight of the dissolution promoter can be less than 300 because it is combined with the less volatile, higher melting point cholate-based dissolution inhibitor. In this embodiment, the dissolution inhibitor is about 90 weight percent to about 10 weight percent of the carboxylic acid derivative dissolution inhibitor and about 10 weight percent to about 90 weight percent of the cholate-based dissolution inhibitor.

Cholate-based dissolution inhibitors are described in U.S. Patent No. 5,879,857 to Houlihan et al. and U.S. Patent No. 5,310,619 to Crivello et al., both of which are incorporated by reference. As used herein, a cholate based dissolution inhibitor has at least one cholate fused ring moiety with at least one acid labile moiety attached thereto. The cholate-based dissolution inhibitor can be either monomeric (i.e. one cholate fused ring structure) or oligomeric (two or more cholate fused ring structures). A cholate fused ring structure has three fused six-member rings and one fused five-member ring represented by the following structure:

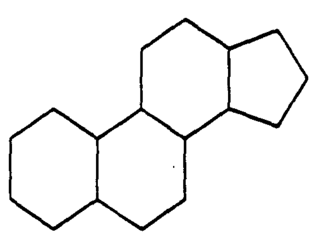

Examples of suitable monomeric cholates include t-butyl cholate, t-butyl lithocholate, and t-butyl deoxycholate. Examples of oligomeric cholate-based dissolution inhibitors are the condensation reaction product of a cholate compound that has a carboxylic acid substituent on the five-member ring and a difunctional carboxylic acid or difunctional carboxylic acid halide (e.g. di-ti-butylcholayl glutarate).

In one embodiment, the resist material is formed by combining a polymer that is relatively soluble in an aqueous base solution, the dissolution inhibitor, and a PAG. In a second embodiment, the resist material is formed by combining a polymer, which is relatively insoluble in aqueous base solution, with the dissolution inhibitor and a PAG. In all embodiments, the PAG generates photoacid when the resist is irradiated. The photoacid so generated, typically in conjunction with the application of heat (referred to as a post-exposure bake), promotes a chemical change that increases the aqueous base solubility of the irradiated resist. Resist materials containing the above-described dissolution inhibitors have properties such as good adhesion and good contrast which make them advantageous for use in processes for device fabrication.

In the process, the energy-sensitive material is selectively exposed to radiation with a wavelength in the range of about 190 nm to about 300 nm to form an image of a desired pattern in the energy-sensitive material. That pattern is then developed and used in subsequent processing. Because the dissolution inhibitors described herein do not significantly absorb radiation at 193 nm, the dissolution inhibitors are particularly advantageous if used in lithographic processes in which the exposing radiation has a wavelength of about 193 nm.

Consequently, it is advantageous if the polymer selected for use in conjunction with the dissolution inhibitor is also compatible with lithographic process for device fabrication in which the exposing radiation is about 190 nm to about 300 nm. Polymers contemplated for use in the process of the present invention include acrylate-based resins that are soluble in aqueous base solution. Examples of such acrylate-based resins are described in Allen, R.D., et al., Photopolymer Science and Technology, Vol. 8, p. 623 (1995), which is incorporated by reference herein.

In one exemplary embodiment, the polymer contains alicyclic moieties that are incorporated either in the polymer backbone or attached to the polymer backbone via saturated hydrocarbon linkages. Such polymers are described in U.S. Patent No. 5,843,624 to Houlihan et al. The alicyclic moiety is advantageous because the polymers with alicyclic moieties therein have an advantageous resistance to plasma etching that is useful in processes for device fabrication. Examples of suitable polymers include terpolymers of norbornene, maleic anhydride and acrylate or methacrylate.

In this embodiment, the polymer is a copolymer of an alicyclic moiety-containing monomer (alicyclic monomer hereinafter) and at least two other monomers. The alicyclic moiety in the monomer is one or more hydrocarbon rings with one or more ethylenically unsaturated bonds. The ethylenic functionality of the monomer is either contained in the hydrocarbon ring or pendant to the hydrocarbon ring. The alicyclic monomer is either substituted or unsubstituted. Examples of suitable substituent groups include alkyl groups, carbonyl groups, carboxylate groups, hydroxyl groups and nitrile groups. These groups are offered by way of example only. Substituent groups that do not absorb radiation at the wavelength of the exposing radiation are contemplated as suitable. Examples of suitable alicyclic monomers are cycloolefins such as norbornene and 5,6-dihydrodicyclopentadiene and cyclodiolefins such as 1,5-cyclooctadiene and 1,5-dimethyl-1, 5-cyclooctadiene.

The second monomer is one that copolymerizes with the alicyclic monomer via a free radical polymerization. It is advantageous if the second monomer undergoes free-radical polymerization with the first monomer in a manner that incorporates the alicyclic moiety in the polymer backbone. Examples of suitable monomers include maleimide monomers, and maleic anhydride monomers. In the embodiment of the invention in which the exposing radiation has a wavelength of 193 nm, it is advantageous if the monomer is selected so that the resulting polymer contains a lithographically insignificant amount of ethylenic unsaturation or other functionality with an absorbance that is too high at the wavelength of the exposing radiation. In the context of the present invention, "lithographically insignificant" means that the amount is not sufficient to cause adverse lithographic consequences. Maleic anhydride is an example of a monomer that is suitable for copolymerization with the alicyclic moiety to provide a polymer that is useful in lithographic processes in which the exposure wavelength is 193 nm.

If it is desired for the polymer to be inherently soluble in aqueous base, the above-described monomers either have a base soluble group (e.g. norbornene carboxylic acid) or are polymerized with a third monomer such as an acrylic acid or a methacrylic acid. The third monomer or monomers are chosen to further enhance the performance of the resist materials in lithographic processes for device fabrication. In this regard, factors such as aqueous base solubility, substrate adhesion, thermal stability and the absorbance of the other monomers at the wavelength of the exposing radiation are considered in making the selection. Other factors such as the glass transition temperature of the resulting polymer are also considered in selecting additional monomers. One skilled in the art will appreciate the various factors in considering the monomers from which to form polymers that are suitable for use in the process of the present invention. Suitable additional monomer or monomers do not hinder the free radical polymerization of the first and second monomer. Specifically, the other monomer or monomers are selected so that the resulting polymer contains about five mole percent to about 50 mole percent of these other monomers. Preferably the resulting polymer contains about five mole percent to about 45 mole percent of these monomers.

One example of a suitable polymer that is inherently soluble in aqueous base is the polymerization product of a norbornene monomer, a maleic anhydride monomer, and an acrylic acid or methacrylic acid monomer. One example of the above-described polymer is represented by the following structure:

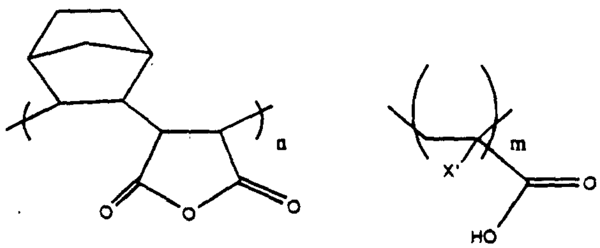

wherein n = about 0.95 to about 0.5, m = about 0.05 to about 0.5, and n+m=1. Embodiments wherein n = about 0.95 to about 0.75 and m = about 0.05 to about 0.25 are viewed to be advantageous. It is advantageous if n = 0.85 to about 0.8 and m = about 0.15 to about 0.2. X' is either hydrogen or methyl.

It is also contemplated that the resist materials may be the polymerization product of more than three monomers. If more than three monomers are used, the fourth, fifth, etc. monomers are selected using the guidelines set forth above for the selection of additional monomers. In one example, the polymer is the polymerization product of four monomers: the monomer with the alicyclic moiety, maleic anhydride, the acrylic or methacrylic acid, and the substituted or unsubstituted acrylate or methacrylate. Although there are two additional monomers in the polymer of this embodiment, the polymer contains about five mole percent to about 50 mole percent of these additional monomers in total.

One example of a suitable inherently insoluble copolymer is the polymerization product of a norbornene monomer, a maleic anhydride monomer, and two acrylate monomers. The resulting polymer is represented by the following structure:

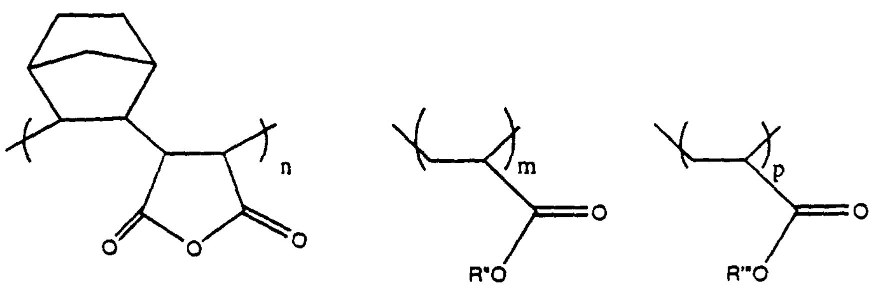

wherein n = about 0.95 to about 0.5, m+p = about 0.05 to about 0.5, and n+m+p = 1. It is advantageous if n = 0.85 to about 0.55 and m+p = about 0.15 to about 0.45. For the above polymer to be inherently insoluble in aqueous base, either R", R"' or both are substituent groups that provide the polymer with the desired insolubility. If one of either R" or R"' is a substituent that provides the polymer with the desired degree of insolubility, then the other of R" or R"' can be hydrogen. If R" is the substituent intended to render the polymer insoluble in aqueous base solution, then R" is an acid labile group. If R"' is the substituent intended to render the polymer insoluble in aqueous base solution, then R"' is an acid labile group. In the embodiment wherein one of R" and R"' is an acid labile group and the other of R" and R"' is hydrogen, the relative amount of m and p in the polymer is selected so that the polymer has the requisite degree of insolubility in aqueous base solution and has the requisite degree of differential solubility between the exposed resist material and the non-exposed resist material.

As noted above, the PAG generates an acid (the "photoacid" hereinafter) when the resist material is exposed to radiation. In this embodiment, the resist material is about 0.5 weight percent to about 20 weight percent (based on the weight of the polymer and dissolution inhibitor) PAG combined with the above-identified terpolymer. If the PAG content is above about 15 weight percent of the combined dissolution inhibitor/polymer, the optical density of the resist material may be too high and its presence above this concentration may hinder development.

In the embodiment wherein the resist material is used in a lithographic process in which the wavelength of the exposing radiation has a wavelength of about 193 nm, the amount of PAG depends upon the composition of the PAG. If the PAG contains an aromatic moiety, it is advantageous if the amount of PAG in the resist material is about 0.5 to about 4 weight percent, because the aromatic unsaturation in these moieties absorbs radiation at this wavelength. In other embodiments wherein radiation of a different wavelength is used, or where a PAG which does not absorb a

lithographically significant amount of the exposing radiation is used, more PAG, about 1 weight percent to about 20 weight percent, is incorporated into the resist material.

The photoacid cleaves the acid labile groups from the dissolution inhibitor (and the polymer, if acid labile groups are present thereon), typically during a post-exposure bake. The cleavage of these groups from the polymer causes the exposed resist material to be more soluble than the unexposed resist material in aqueous base solution. An aqueous base developer solution is then used to dissolve and remove the exposed resist material. The unexposed resist material is then used as a patterned mask for subsequent processing of the underlying substrate; typically for transferring the pattern into the substrate.

In the above-described embodiments, the solubility of the resist composition in aqueous base solution is altered when the resist material is exposed to radiation. Since the resist materials of the present invention are positive resists, the aqueous base solubility of the exposed resist is greater than the aqueous base solubility of the resist that is not exposed to radiation. If the ratio of the rate of dissolution of the resist before irradiation compared to that after irradiation is taken as 1:n, n should be not be less than 2. Relative solubility ratios with values of n less than 2 typically produce low contrast and inferior image quality.

An appropriate optical density in the wavelength range of the exposing radiation significantly enhances resist quality. Too low an optical density results in inefficient absorption of the exposing radiation and in unnecessarily long exposure times. Too high an optical density does not permit sufficient light to reach the regions of the polymer film furthest removed from its ambient/resist film interface. This incomplete exposure tends to degrade resist image quality. In general, it is desirable to employ an optical density that is preferably less than 0.6 for at least 30 percent of the exposing radiation to reach the substrate at the exposure wavelength.

The optical density depends on the concentration of the absorbing species in both the polymer and the PAG. Thus, once a suitable thickness for the resist material coating is chosen, the resist composition is adjusted to provide the desired optical density. For thicknesses as previously discussed in connection with film continuity, if the desired optical density is maintained, useful results are attained.

In the process of the present invention, generally, the resist material described generally above is formed into a film on the surface of a substrate that is typically a silicon wafer. The silicon wafer will typically have layers of other materials formed thereon. These wafers, with or without layers of other materials formed thereon, are referred to herein as substrates.

The thickness of the film depends upon a variety of factors such as the absorption of the resist, the quality of the film, and the effect of thickness on image resolution. Typically, the thickness of the resist film is in the range of about 0.2 µm to about 2 µm.

After coating, the resist is preferably prebaked to remove any remaining solvent. Pre-exposure baking temperatures in the range of 70°C to 170°C for times in the range of about 0.5 to about 60 minutes are desirable. The resist material is then exposed to energy such as ultraviolet radiation with a wavelength of about 190 nm to about 300 nm. Typical doses in the range of 5 to 250 $mJoules/cm^2$ for 193 nm light are contemplated as suitable. Conventional exposure techniques are employed to delineate the resist material. One skilled in the art will appreciate that the selection of a suitable exposure dose will depend upon the particular resist material that is used, as well as other process variables.

It is then desirable to post exposure bake the exposed material. This post-bake enhances the reaction of, depending upon the particular embodiment, the relatively insoluble dissolution inhibitor and, if applicable, polymer, with the photoacid. Generally, post-bake temperatures in the range of about 70°C to about 170°C for time periods of about 20 seconds to about 30 minutes are effective. Heating means such as a hot plate sold by Brewer Sciences are contemplated as useful.

Solvents suitable for developing the exposed image are materials such as water/tetramethylammonium hydroxide, water/NaOH, or water and base with lower alkyl alcohols such as isopropanol, ethanol, methanol, and mixtures thereof. Generally, immersion in the developer for time periods from 20 seconds to 5 minutes produces the desired delineation.

After the development, the pattern in the resist is transferred into the underlying substrate using conventional etching expedients well known to one skilled in the art.

The following examples are provided to further illustrate exemplary embodiments of the present invention. The examples are not intended by way of limitation, except within the spirit and scope of the appended claims.

In the following examples, all starting materials were obtained from the Aldrich Chemical Company. The t-butyl esters (i.e., di-t-butyl oxalate, di-t-butyl malonate and di-t-butyl 1,3-acetonedicarboxylate) and the base additive triphenylimidazole were also obtained from the Aldrich Chemical Company.

## Example 1

Di-t-butyl 1,4-cyclohexanedicarboxylate (an approximately 50/50 mixture of cis and trans isomers) was prepared by dissolving 1,4-cyclohexanedicarboxylic acid (10 grams of a dry (under vacuum 50°C overnight) 50/50 mixture of isomers) in dry THF (150 mL) under argon and cooled to 0°C. Trifluoroacetic anhydride (42.5 mL) was added to the cooled solution while controlling the addition rate to maintain the temperature below 10°C. After the addition, the mixture was allowed to warm to room temperature and stirred at this temperature for 90 minutes. The solution was cooled to 0°C, and dry t-butyl alcohol (45 mL) was added dropwise at a rate that maintained the temperature below 10°C. The reaction mixture was held at a temperature of 0°C and stirred for 10 hours. Concentrated aqueous $NH_4OH$ (50mL) was added to the mixture at 0°C, controlling the addition rate to maintain the mixture at that temperature. The solution was maintained at 0°C and stirred for 24 hours. Ether (250 mL) and water (250 mL) were added, producing a two phase system. The ether phase was separated out and washed three times with water and then concentrated and dried. Recrystallization was done by dissolution in hot methanol (~60 mL) and adding water till cloudy. The product was then reheated until clear and cooled to initiate final crystallization.

The structure of 1,4-cyclohexanedicarboxylate is illustrated by the following structure:

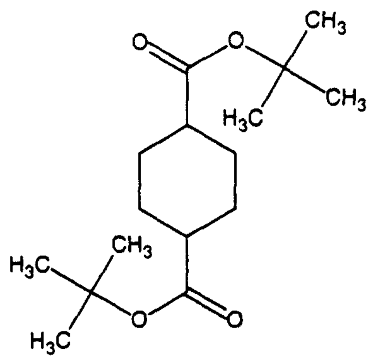

## Example 2

Di-t-butyl 1,4-cyclohexanedicarboxylate (100 trans) was synthesized using the procedure described in Example 1 except that pure trans 1,4-cyclohexanedicarboxylic acid was used as a starting material. After purification, pure crystals of trans di-t-butyl 1,4-cyclohexanedicarboxylic acid were recovered in 90% yield.

## Example 3

Di-t-butyl 1,3-cyclohexane dicarboxylate was synthesized by dissolving dry 1,3-cyclohexanedicarboxylic acid (5 grams of a 50/50 mixture of isomers dried under vacuum 50°C overnight) 1,3-, (50/50 mixture of isomers) in 150 mL of dry THF (150 mL) under argon and cooled to 0°C. To the cooled solution was added dropwise trifluoroacetic anhydride (25 mL) while maintaining the addition rate such that the temperature did not rise above 10°C. After the addition, the mixture was allowed to warm to room temperature and stirred at this temperature for 90 minutes. The solution was cooled then cooled to 0°C, and dry t-butyl alcohol (25 mL) was added dropwise at a rate such that the temperature did not exceed 10°C. The reaction mixture was stirred at 0°C for 10 hours.

Concentrated aqueous $NH_4OH$ (50 mL) was added to the mixture at 0°C at a rate that was controlled to maintain the mixture at that temperature. The solution was stirred at 0°C for 24 hrs. Ether (150 mL) and water (150 mL) were added to produce a two-phase system. The ether phase was separated out and washed three times with water and then concentrated and dried. After removal of the ether and drying under vacuum 4.8 grams (96% yield) of a clear liquid, di-butyl 1,3-cyclohexanedicarboxylic acid, was recovered. Di-butyl 1,3-cyclohexanedicarboxylic acid is illustrated by the following structure:

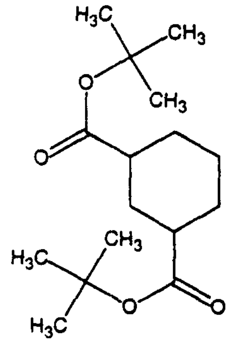

## Example 4

Tri-t-butyl 1,3,5-cyclohexanetricarboxylate was synthesized by dissolving dry, 1,3,5-cyclohexanetricarboxylic acid (10 grams dried under vacuum at 50°C overnight) dry THF (150 mL) under argon and cooled to 0°C. To the cooled solution was added, dropwise, trifluoroacetic anhydride (73.9 mL) while maintaining the addition rate such that the temperature did not rise above 10°C. After the addition, the mixture was allowed to warm to room temperature and stirred at this temperature for 90 minutes. The solution was then cooled to 0°C, and dry t-butyl alcohol (199 mL) was added dropwise at a rate such that the temperature did not exceed 10°C. The reaction mixture was stirred at 0°C for 10 hours.

Concentrated aqueous $NH_4OH$ (170 mL) was added to the mixture at 0°C. The addition rate was controlled to maintain the solution temperature at 0°C. The solution temperature was maintained at 0°C and the solution was stirred for 24 hours. 650 mL of Ether (650 mL) and water (650 mL) were added, resulting in a two-phase system. The ether phase was separated out and washed three times with water and then concentrated and dried. The residue was recrystallized three times by dissolving the residue into acetone (50 mL) and adding water (20 mL). The final product was dried under vacuum overnight to give 4.75 grams of white crystalline, pure tri-t-butyl 1,3,5-cyclohexanetricarboxylate (27% yield). Tri-t-butyl 1,3,5-cyclohexanetricarboxylate is illustrated by the following structure:

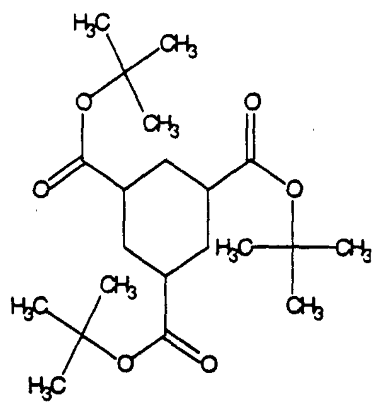

## Example 5

Di-t-butyl n-butylmalonate was synthesized by dissolving dry, n-butylmalonic acid (25 grams dried under vacuum 50°C overnight) in 200 mL of dry THF under argon and cooled to 0°C. To the cooled solution was added dropwise trifluoroacetic anhydride (88.5 mL). The addition rate was controlled such that the temperature did not rise above 10°C. The mixture was then allowed to warm to room temperature and stirred at this temperature for 90 minutes. The solution was then cooled to 0°C, and dry t-butyl alcohol (119 mL) was added dropwise at a rate selected to maintain the solution temperature at less than 10°C. The solution temperature of the reaction mixture was maintained at 0°C and the solution was stirred for 10 hours.

Concentrated aqueous $NH_4OH$ (200 mL) was added to the mixture. The addition rate was controlled to maintain the temperature of the reaction mixture at 0°C. The solution temperature was maintained 0°C and the solution was stirred for 24 hrs. Ether (650 mL) and water (650 mL) were added, resulting in a two-phase system. The ether

phase was separated out and washed three times with water and then concentrated and dried. The ether was removed under vacuum to give clear liquid (39.13 grams) that consisted mainly of di-t-butyl n-butylmalonate. The liquid was purified by distillation under high vacuum to give a fraction between 80°C and 90°C that consists of pure di-t-butyl n-butyl malonate. Di-t-butyl n-butyl malonate is illustrated by the following structure:

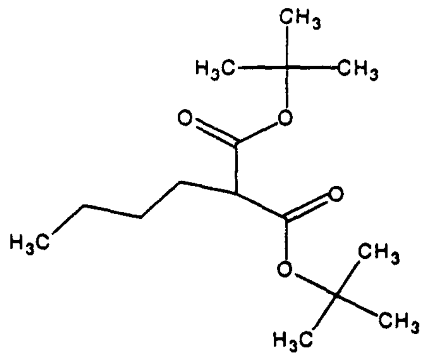

**Example 6**

A tetrapolymer of norbornene, maleic anhydride, t-butyl acrylate and acrylic acid was synthesized according to the following procedure. Norbornene (16.41 g; 174 mmol) was vacuum-transferred into a dry 500 mL Schlenk flask equipped with two PTFE-stoppered inlet valves and an efficient stir-bar. Freshly sublimed maleic anhydride (17.09 g; 174 mmol), distilled t-butyl acrylate (4.46 g; 34.8 mmol), and distilled acrylic acid (2.51 g; 34.8 mmol), AIBN (0.286 g; 1 mole percent), and THF (40 mL) were added under positive argon pressure. The mixture was degassed by three freeze-pump-thaw cycles, sealed, and immersed in an oil bath at 65°C for 18 hours. Upon cooling, the mixture was precipitated into 5 volumes of diethyl ether and filtered to collect the polymer. Upon cooling, the mixture was precipitated into 5 volumes of diethyl ether and filtered to collect the polymer. This process was repeated three more times. The polymer was collected'in the final filtration and dried at 50°C under vacuum.

**Example 7**

Resist materials were prepared by combining tris(t-butylphenyl)sulfonium nonaflate (a PAG), a resist polymer, a dissolution additive (either one material or a two component mixture) and a base additive with a spinning solvent. The resist material contained about 15 percent by weight solids (i.e., polymer, dissolution, inhibitor, base additive and PAG). The amount of PAG in the formulations was 2.06 percent of the solids (i.e. the PAG, polymer, base additive and dissolution additive). The total amount of dissolution additive was 25 weight percent of the solids. The composition of the dissolution additive was varied from 100 percent to 16 percent of a t-butyl carboxylate derivative (e.g. di-t-butyl malonate, di-t-butyl oxalate, di-t-butyl 1,3-acetonedicarboxylate or the t-butyl carboxylate derivatives described in examples 1-8). The other portion of the dissolution additive composition was a cholate-type dissolution additive (e.g. t-butyl cholate or di-t-butylcholalyl glutarate). The remaining portion of the resist was the resist polymer. The resist polymer used in this example was a quaternary polymer of norbornene, maleic anhydride, t-butyl acrylate and acrylic acid (poly(NB-alt-MA-co-TBA-co-AA) in which about 2 wt percent of the repeat units consisted of acrylic acid, 23 weight percent -butyl acrylate repeat unit, 30 weight percent norbornene and 44 weight percent maleic anhydride. The polymer was prepared as described in example 8.

The resist formulations, dissolved in 2-heptanone, were passed through PTFE filter membranes (0.2-0.45 micron) prior to casting. Films were formed on HMDS-primed silicon wafers by spinning the wafers at a speed (1,100-2,000) so as to obtain a film thickness of 0.4017 microns and then baking the wafers at 145°C for 90 seconds. The films were exposed to radiation with a wavelength of 193 nm and a dose in the range of 1 $mJ/cm^2$ to 50 $mJ/cm^2$. The exposure tool used was an ISI 0.6 NA (numerical aperture) small field catadioptric exposure system. The tool was used with optics that reduced the image by a factor of ten, and the tool had a partial coherence of 0.7.

After exposure the films were baked at 160°C for 120 seconds. The formulations and the clearing dose and contrast factor of these formulations from 193-nm exposure are summarized in the following Table 1.

Table 1

| Sample | Dissolution Additive [a] | EO mJ/$cm^2$ | Contrast | Resolution Dose mJ/ $cm^2$ (Depth of Focus)[b] | Appearance of Dense lines[b] | Minimum Resolution (μm)[b] |
|---|---|---|---|---|---|---|
| 1 | t-butyl cholate (1%) + di-t-butylcholalyl glutarate (24%) | 9.2 | 9.8 | 19.5 (0.6) | Profiles OK | 0.145 slight scum |
| 2 | di-t-butyl 1,4-cyclohexanedicarboxylate (cis +trans 50/50 mixture) (25%) | 13.8 | 19.6 | 22.7 (0.5) (ignoring T-top) | Heavily Undercut; T-top | 0.15 (Ignoring t-topping; with slight scum) |
| 3 | di-t-butyl 1,4-cyclohexanedicarboxylate (trans) (25%) | 14.6 | 21.1 | 24.3 (0.4) (ignoring T-top) | Heavily Undercut; T-top | 0.145 (ignoring T-top) |
| 4 | di-t-butyl ester 1,4-cyclohexanedicarboxylate (trans ) (24%) + t-butyl cholate (1 %) | 14.6 | 21.0 | 20.5 (0.7) | Vertical profiles | 0.145 (slight scum) |
| 5 | di-t-butyl 1,4-cyclohexanedic arboxylate (trans) (1%)+ di-t-butylcholalyl glutarate (24%) | 8.8 | 24.9 | 17.3 (0.4) | Vertical profiles | 0.15 (slight scum) |
| 6 | di-t-butyl ester 1,3-cyclohexanedic arboxylic acid (25%) | 16.0 | 45.8 | 34.6 (0.4) (ignoring T-top) | Heavily T-topped | 0.16 (Ignoring t-topping with slight scum) |
| 7 | di-t-butyl 1,3-cyclohexanedic arboxylate (trans) (24%) + t-butylcholate (1%) | 7.2 | 16.6 | 15.3 (0.6) | Vertical profiles | 0.15 (slight scum) |
| 8 | di-t-butyl 1,3-cyclohexanedic arboxylate (1%) + di-t-butylcholalyl glutarate (24%) | 9.8 | 20.1 | 19.8 (0.6) | Vertical profiles | 0.145 (slight scum) |
| 9 | di-t-butyl n-butylmalonate (25%) | 17.8 | 13 | 30.4 (too heavily T-topped to determine) | Heavily t-topped undercut | 0.16 |
| 10 | di-t-butyl n-butylmalonate (24%) + t-butyl cholate (1%) | 13.0 | 28.4 | 25.3 (0.7) | OK, but slight t-top | 0.145 (slight scum) |
| 11 | di-t-butyl n-butylmalonate acid (1%) + di-t-butylcholalyl glutarate (24%) | 9.2 | 18.7 | 19.8 0.6 | OK | 0.145 (slight scum) |
| 12 | di-t-butyl malonate | 15.8 | 73.3 | | | |
| 13 | di-t-butyl malonate (24%)+ t-butyl cholate (1%) | 14.6 | 25.4 | | | |
| 14 | di-t-butyl malonate (1%) + di-t-butylcholalyl glutarate (24 %) | 8.2 | 20.8 | | | |
| 15 | di-t-butyl oxalate (1%) + di-t-butylcholalyl glutarate (24%) | 8.4 | 20.4 | | | |
| 16 | di-t-butyl 1,3-acetonedicarbo xylate 1% + di-t-butylcholalyl glutarate (24 %) | 8.6 | 21.3 | | | |

[a] Weight percent of solids in resist formulations. All resist formulations contained, in additionto the dissolution additive described, the resist polymer, PAG and base described in Example 8.

[b] Optimized for 0.16 μm features.

Table 1 (continued)

| Sample | Dissolution Additive [a] | EO mJ/cm$^2$ | Contrast | Resolution Dose mJ/ cm$^2$ (Depth of Focus)[b] | Appearance of Dense lines[b] | Minimum Resolution (μm)[b] |
|---|---|---|---|---|---|---|
| 17 | Tri-t-butyl 1,3,5-cyclohexanetri carboxylate (25%) | 9.74 | 27 | 19.9(0.6) | OK | 0.14 |

[a] Weight percent of solids in resist formulations. All resist formulations contained, in additionto the dissolution additive described, the resist polymer, PAG and base described in Example 8.
[b] Optimized for 0.16 μm features.

Table 1 illustrates that the blend of dissolution inhibitors (a dissolution promoter combined with a cholate-based dissolution inhibitor) provides higher contrasts (17-25) than formulations containing a blend of monomeric and oligomeric cholate-based materials (Sample 1). High contrast is advantageous for high-resolution resists. In addition, better wall profiles and less T-topping was observed for features developed in the resists having the blend of dissolution inhibitors.

It is advantageous if the aliphatic carboxylic acid derivative dissolution inhibitor of the present invention, when used as a single component dissolution inhibitor has a molecular weight of about 300 to about 2000. Although applicants do not wish to be held to a particular theory, applicants believe that such dissolution inhibitors are less volatile (compared to aliphatic carboxylic acid derivatives with a molecular weight of less than 300). The applicants attribute this difference in volatility to the fact that the dissolution inhibitors with a molecular weight above 300 have boiling points above 300°C. The advantage of the higher molecular weight compounds is that they are useful as sole dissolution inhibitor component. Because of their decreased volatility, they are more evenly distributed throughout the resist during the spinning and baking steps (compared to the lower molecular weight materials). Uneven distribution of the dissolution inhibitor can cause uneven development, which manifests itself in undesired effects such as T-topping (i.e. for a line feature, the top of the line is thicker than the bottom of the line).

However, aliphatic carboxylic acid derivatives with molecular weights of about 100 to about 300, although not useful as a single component dissolution inhibitor, are useful as a dissolution promoter when combined with a higher molecular weight dissolution inhibitor. Such dissolution inhibitors, when combined with a dissolution promoter, are described as a blend herein.

The aliphatic carboxylic acid derivative dissolution inhibitors of the present invention that have a molecular weight of about 300 to about 2000 also provide the resist material with an advantageous dissolution rate (defined as $R_{max}$). That is, the $R_{max}$ of resists that have such dissolution inhibitors are higher than the $R_{max}$ of resists that have cholate-based dissolution inhibitors, and blends thereof, or more volatile (i.e. molecular weight less than 300) non-cholate dissolution inhibitors.

Applicants measured the $R_{max}$ for a number of different resist materials. The measured $R_{max}$ for a resist in which the dissolution inhibitor was tri-t-butyl 1,3,5-cyclohexanetricarboxylate blended with t-butyl cholate was 500 nm/ second. The measured $R_{max}$ for a resist in which the dissolution inhibitor was tri-t-butyl 1,3,5-cyclohexanetricarboxylate alone was over 600 nm/ second. As demonstrated by Table 2, the $R_{max}$ for resist materials with cholate derivative dissolution inhibitors or blends thereof was lower (170-260 nm/sec). Similarly, the $R_{max}$ of resist materials in which the dissolution inhibitor was a lower molecular with aliphatic carboxylic acid derivative (e.g. di-t-butyl ester 1,4-cyclohexanedicarboxylate, di-t-butyl ester 1,4-cyclohexanedicarboxylate) was lower (270-300 nm/sec).

TABLE 2

| Dissolution inhibitor (Wt % loading in resist)[a] | Rmax. nm/sec |
|---|---|
| t-butyl cholate (1%) + di-t-butylcholalyl glutarate (24%) | 220 |
| t-butyl cholate (25%) | 260 |
| t-butyl lithocholate (25%) | 140 |
| t-butyl deoxycholate (25%) | 170 |
| Tri-t-butyl 1,3,5-cyclohexanetricarboxylate (25%) | >600 |

[a] Weight percent of solids in resist formulations. All resist formulations contained, in addition to the dissolution additive described, the resist polymer, PAG and base described in Example 8.

TABLE 2 (continued)

| Dissolution inhibitor (Wt % loading in resist)[a] | Rmax. nm/sec |
|---|---|
| Tri-t-butyl 1,3,5-Cyclohexanetricarboxylate (24%), t-butyl cholate (1%) | 500 |
| di-t-butyl ester 1,4-cyclohexanedicarboxylic acid (25%) | 320 |
| di-t-butyl ester 1,3-cyclohexanedicarboxylate \ (25%) | 280 |
| t-butyl ester n-butylmalonate (25%) | 270 |

[a] Weight percent of solids in resist formulations. All resist formulations contained, in addition to the dissolution additive described, the resist polymer, PAG and base described in Example 8.

## Claims

**1.** A process for device fabrication comprising:

forming a layer of an energy sensitive resist material on a substrate wherein the energy sensitive resist material comprises a photoacid generator, a polymer, and a dissolution inhibitor wherein the dissolution inhibitor comprises an aliphatic carboxylic acid derivative that has at least two carboxylic acid moieties and has the following formula:

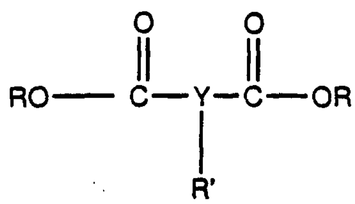

wherein R is an acid labile group, Y is an aliphatic moiety that is selected from the group consisting of linear or branched chain alkyl moieties, cyclic alkyl and alicyclic alkyl moieties wherein the number of carbon atoms does not exceed about 18 and R' is selected from the group consisting of hydrophilic substituents having an acid labile group, alkyl substituents, alkoxy substituents, sulfone substituents, hydroxy substituents and cyano substituents wherein R' has no more than about 18 carbon atoms;
exposing the layer of energy sensitive resist material to patterned radiation selected from the group consisting of ultraviolet radiation, x-ray radiation, and electron beam radiation thereby introducing an image of the pattern into the resist material;
developing the image into a pattern; and
transferring the pattern into the underlying substrate.

**2.** The process of claim 1 wherein the dissolution inhibitor is about 5 weight percent to about 95 weight percent of the aliphatic carboxylic acid derivative combined with about 95 weight percent to about 5 weight percent of a cholate-based monomer.

**3.** A process for device fabrication comprising:

forming a layer of an energy sensitive resist material on a substrate wherein the energy sensitive resist material comprises a photoacid generator, a polymer, and a dissolution inhibitor wherein the dissolution inhibitor is about 5 weight percent to about 95 weight percent of a dissolution promoter that is an aliphatic carboxylic acid derivative that has at least two carboxylic acid moieties and is selected from the group consisting of:

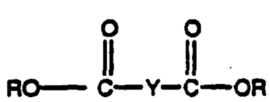
and
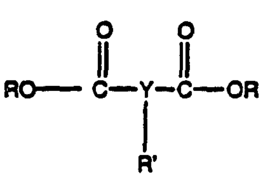

wherein R is an acid labile group, Y is an aliphatic moiety that is selected from the group consisting of linear or branched chain alkyl moieties, cyclic alkyl and alicyclic alkyl moieties wherein the number of carbon atoms does not exceed about 18 and R' is selected from the group consisting of hydrophilic substituents having an acid labile group, alkyl substituents, alkoxy substituents, sulfone substituents, hydroxy substituents and cyano substituents wherein R' has no more than about 18 carbon atoms combined with about 95 weight percent to about 5 weight percent of a cholate-based monomer;
exposing the layer of energy sensitive resist material to patterned radiation selected from the group consisting of ultraviolet radiation, x-ray radiation, and electron beam radiation thereby introducing an image of the pattern into the resist material;
developing the image into a pattern; and
transferring the pattern into the underlying substrate.

**4.** The process of claim 1 or 3 wherein R' is an alkyl substituent selected from the group consisting of linear or branched chain alkyl moieties, cyclic alkyl moieties, and alicyclic alkyl moieties that has no more than about 18 carbon atoms.

**5.** The process of claim 4 wherein the cyclic and alicyclic Y moieties are selected from the group consisting of

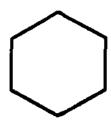
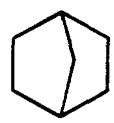

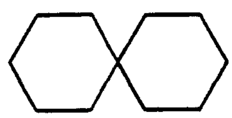
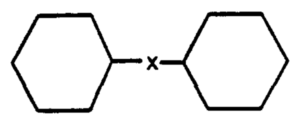

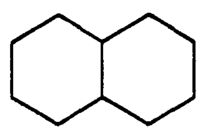

wherein X is selected from the group consisting of oxygen, branched or straight chain alkyl moieties having no more than about 18 carbon atoms, alicyclic moieties, sulfur-containing moieties and carboxyl moieties.

**6.** The process of claim 1 or 3 wherein the acid labile groups are selected from the group consisting of t-butyl, t-amyl, 1-methylcyclohexyl, 3-oxocyclohexyl, and bis(2-trimethylsilyl)ethyl.

**7.** The process of claim 3 wherein the molecular weight of the dissolution promoter is about 100 to about 2000 daltons.

**8.** The process of claim 1 or 3 wherein the polymer is selected from the group consisting of acrylate-based polymers which are soluble in aqueous base, methacrylate-based polymers which are soluble in aqueous base and polymers with alicyclic moieties incorporated into the polymer backbone, and polymers with alicyclic substituents pendant to the polymer chain.

**9.** The process of claim 8 wherein the exposing radiation is ultraviolet radiation with a wavelength of about 190 nm to about 300 nm.

**10.** The process of claim 9 wherein the exposing radiation is ultraviolet radiation with a wavelength of about 193 nm.

**11.** The process of claim 10 wherein the polymer is selected from the group consisting of terpolymers of norbornene, maleic anhydride, and acrylic acid, or methacrylic acid and tetrapolymers of norbornene, maleic anhydride, acrylic

acid or methacrylic acid and acrylate or methacrylate.

**12.** An energy sensitive resist material comprising
a photoacid generator, a polymer, and a dissolution inhibitor wherein the dissolution inhibitor comprises an aliphatic carboxylic acid derivative that has at least two carboxylic acid moieties and has the following formula:

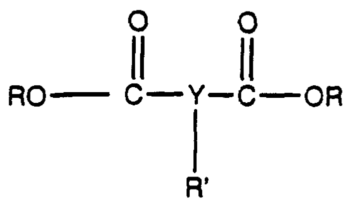

wherein R is an acid labile group, Y is an aliphatic moiety that is selected from the group consisting of linear or branched chain alkyl moieties, cyclic alkyl and alicyclic alkyl moieties wherein the number of carbon atoms does not exceed about 18 and R' is selected from the group consisting of hydrophilic substituents having an acid labile group, alkyl substituents, alkoxy substituents, sulfone substituents and cyano substituents wherein R' has no more than about 18 carbon atoms.

**13.** The resist material of claim 12wherein R' is an alkyl substituent selected from the group consisting of linear or branched chain alkyl moieties, cyclic alkyl moieties, and alicyclic alkyl moieties that has no more than about 18 carbon atoms.

**14.** The resist material of claim 13 wherein the cyclic and alicyclic Y moieties are selected from the group consisting of

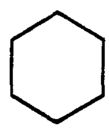
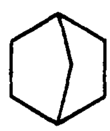

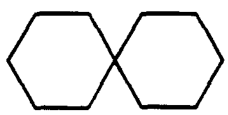
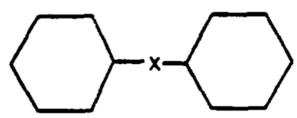

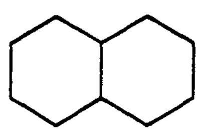

wherein X is selected from the group consisting of oxygen, branched or straight chain alkyl moieties having no more than about 18 carbon atoms, alicyclic moieties, sulfur-containing moieties and carboxyl moieties.

**15.** The resist material of claim 12 wherein the acid labile groups are selected from the group consisting of t-butyl, t-amyl, 1-methylcyclohexyl, 3-oxocyclohexyl, and bis(2-trimethylsilyl)ethyl.

**16.** The resist material of claim 12 wherein the dissolution inhibitor is about 5 weight percent to about 95 weight percent of the aliphatic carboxylic acid derivative combined with about 95 weight percent to about 5 weight percent of a cholate-based monomer.

**17.** The resist material of claim 12wherein the polymer is selected from the group consisting of acrylate-based polymers

which are soluble in aqueous base, methacrylate-based polymers which are soluble in aqueous base and polymers with alicyclic moieties incorporated into the polymer backbone, and polymers with alicyclic substituents pendant to the polymer chain.

**18.** The resist material of claim 17 wherein the polymer is selected from the group consisting of terpolymers of norbornene, maleic anhydride, and acrylic acid, or methacrylic acid and tetrapolymers of norbornene, maleic anhydride, acrylic acid or methacrylic acid and acrylate or methacrylate.

**19.** An energy sensitive resist material comprising:

a photoacid generator, a polymer, and a dissolution inhibitor wherein the dissolution inhibitor wherein the dissolution inhibitor is about 5 weight percent to about 95 weight percent of a dissolution promoter that is an aliphatic carboxylic acid derivative that has at least two carboxylic acid moieties and is selected from the group consisting of:

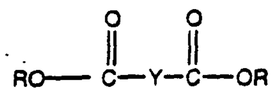

and

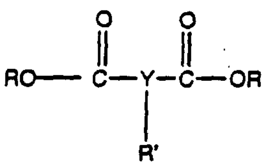

wherein R is an acid labile group, Y is an aliphatic moiety that is selected from the group consisting of linear or branched chain alkyl moieties, cyclic alkyl and alicyclic alkyl moieties wherein the number of carbon atoms does not exceed about 18 and R' is selected from the group consisting of hydrophilic substituents having an acid labile group, alkyl substituents, alkoxy substituents, sulfone substituents and cyano substituents wherein R' has no more than about 18 carbon atoms combined with about 95 weight percent to about 5 weight percent of a cholate-based monomer.

European Patent Office

# EUROPEAN SEARCH REPORT

Application Number
EP 00 30 7367

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | T. OKINO ET AL.: "Chemically Amplified Resists Using the Absorption Band Shift Method in Conjunction with Alicyclic Compounds for ArF Excimer Laser Lithography" PROCEEDINGS OF THE SPIE - THE INTERNATIONAL SOCIETY FOR OPTICAL ENGINEERING, vol. 3678, no. 1, 15 March 1999 (1999-03-15), pages 582-590, XP002162816 USA * page 583, paragraph 1 * --- | 1,3,4, 6-10,12, 13,15, 17,19 | G03F7/039 G03F7/004 |
| X | GB 2 337 518 A (SAMSUNG ELECTRONICS CO., LTD.) 24 November 1999 (1999-11-24) * claims 6-30 * --- | 1,3,4,6, 7,9,10, 12,13, 15,19 | |
| X | US 5 310 619 A (J.V. CRIVELLO ET AL.) 10 May 1994 (1994-05-10) * column 4, line 25 - line 30 * * column 5, line 17 - line 24 * * examples 7,9 * --- | 1,3,4,6, 7,9,12, 13,15,19 | TECHNICAL FIELDS SEARCHED (Int.Cl.7) G03F |
| A,D | US 5 879 857 A (E.A. CHANDROSS ET AL.) 9 March 1999 (1999-03-09) * figure 1 * * column 6 * --- | 1-19 | |
| A,D | US 5 843 624 A (F.M. HOULIHAN ET AL.) 1 December 1998 (1998-12-01) * column 15; example 6 * ----- | 1-19 | |

The present search report has been drawn up for all claims

| Place of search | Date of completion of the search | Examiner |
|---|---|---|
| THE HAGUE | 14 March 2001 | Dupart, J.-M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 00 30 7367

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2001

| Patent document cited in search report | Publication date | Patent family member(s) | Publication date |
|---|---|---|---|
| GB 2337518 A | 24-11-1999 | DE 19843089 A | 25-11-1999 |
| | | JP 11352696 A | 24-12-1999 |
| | | US 6165680 A | 26-12-2000 |
| US 5310619 A | 10-05-1994 | CA 1332119 A | 27-09-1994 |
| | | US 5362607 A | 08-11-1994 |
| | | DE 3750275 D | 01-09-1994 |
| | | DE 3750275 T | 09-03-1995 |
| | | EP 0249139 A | 16-12-1987 |
| | | JP 2714378 B | 16-02-1998 |
| | | JP 63027829 A | 05-02-1988 |
| | | KR 9507226 B | 04-07-1995 |
| | | IE 64507 B | 09-08-1995 |
| | | MX 169013 B | 17-06-1993 |
| US 5879857 A | 09-03-1999 | US 5843624 A | 01-12-1998 |
| | | DE 69800033 D | 02-12-1999 |
| | | DE 69800033 T | 20-07-2000 |
| | | EP 0880074 A | 25-11-1998 |
| | | JP 10307401 A | 17-11-1998 |
| | | US 5998099 A | 07-12-1999 |
| US 5843624 A | 01-12-1998 | US 5998099 A | 07-12-1999 |
| | | US 5879857 A | 09-03-1999 |
| | | EP 0794458 A | 10-09-1997 |
| | | JP 10010739 A | 16-01-1998 |

EPO FORM P0459

For more details about this annex : see Official Journal of the European Patent Office, No. 12/82